# EUROPEAN PATENT APPLICATION

(11) **EP 3 920 411 A1**
(43) Date of publication of application: **08.12.2021**
(21) Application number: 20919838.1
(22) Date of filing: 05.06.2020
(51) Int. Cl.: H02S 30/10

(54) **SHUTTER PHOTOVOLTAIC BLADE**

(30) Priority: 17.02.2020 CN 202020176624 U
(71) Applicant: Hengdian Group DMEGC Magnetics Co. Ltd., Dongyang, Zhejiang 322118 (CN)
(72) Inventor: WANG, Tingting, Jinhua, Zhejiang 322118 (CN); LOU, Caoxin, Jinhua, Zhejiang 322118 (CN); LI, Xiaoxia, Jinhua, Zhejiang 322118 (CN); LU, Jiangkai, Jinhua, Zhejiang 322118 (CN)
(74) Representative: Cabinet Beaumont
(86) International application number: PCT/CN2020/094711
(87) International publication number: WO 2021/164149

(57) **Abstract**

Provided is a photovoltaic slat for a louver. The photovoltaic slat for a louver includes a photovoltaic assembly, a first frame, a photovoltaic cable and two second frames. Two sides of the first frame are provided with two slide grooves having opposite openings, two side edges of the photovoltaic assembly are respectively inserted into two slide grooves, and a lead groove is disposed on a side surface of the first frame facing the photovoltaic assembly. The photovoltaic cable is disposed in the lead groove and is configured to draw electric energy generated by the photovoltaic assembly. Each of the two second frames is connected to a respective one of two ends of the first frame which are not provided with the two slide grooves, the photovoltaic assembly is clamped between the two second frames, and a lead hole for the photovoltaic cable to pass through is provided in each of the two second frames.

## Description

This application claims priority to Chinese Patent Application No. 202020176624. X filed on Feb. 17, 2020, the disclosure of which is incorporated herein by reference in its entirety.

### TECHNICAL FIELD

The present application relates to the photovoltaic technical field, for example, to a photovoltaic slat for a louver.

### BACKGROUND

In order to increase the capability of a building itself to generate power resources, in the related art, a solar power generation device is generally integrated on a roof or a window. For example, an integrated louver formed by integrating a louver and a photovoltaic assembly is designed. Electric energy generated by the integrated louver every day not only can provide daily power for household appliances, but also can be stored in a battery system for emergency use in case of power failure. Moreover, in summer, the integrated louver can effectively shield against solar radiation and restrain indoor temperature from sharply increasing, so that the energy consumption of an indoor air conditioner is reduced, the emission of indoor greenhouse gases is reduced, and the effects of energy conservation and environmental protection are achieved.

The integrated louver includes multiple photovoltaic slats. In order to connect the photovoltaic slats to a frame of a window, holes need to be punched on the photovoltaic slats. However, punching holes on photovoltaic slats puts forward high requirements on punching process and punching positions, and daylighting capability of the photovoltaic slats is reduced. Moreover, for photovoltaic slats in the related art, generated electric energy is generally drawn through photovoltaic cables, but when the photovoltaic slats are applied to a louver, multiple photovoltaic slats distributed from top to bottom are required, resulting in a large number of photovoltaic cables and disorderly distribution.

### SUMMARY

The present application provides a photovoltaic slat for a louver, which can make photovoltaic cables invisible without punching holes on the photovoltaic slat, and thus improve the aesthetic performance and the safety performance of the photovoltaic slat for a louver.

An embodiment provides a photovoltaic slat for a louver. The photovoltaic slat for a louver includes a photovoltaic assembly, a first frame, a photovoltaic cable and two second frames.

Two sides of the first frame are provided with two slide grooves having opposite openings, two side edges of the photovoltaic assembly are respectively inserted into the two slide grooves, and a lead groove is disposed on a side surface of the first frame facing the photovoltaic assembly.

The photovoltaic cable is disposed in the lead groove and is configured to draw electric energy generated by the photovoltaic assembly.

Each of the two second frames is connected to a respective one of two ends of the first frame which are not provided with the two slide grooves, the photovoltaic assembly is clamped between the two second frames, and a lead hole for the photovoltaic cable to pass through is provided in each of the two second frames.

### BRIEF DESCRIPTION OF DRAWINGS

FIG 1 is an exploded view of a photovoltaic slat for a louver according to an embodiment of the present application;
FIG. 2 is an exploded view of a structure of a photovoltaic assembly and frames of the photovoltaic assembly according to an embodiment of the present application; and
FIG. 3 is a schematic diagram of connection of a battery string according to an embodiment of the present application.

### Reference list

- 1: first frame
- 11: lead groove
- 12: slide groove
- 2: second frame
- 21: lead hole
- 3: photovoltaic cable
- 31: positive cable
- 32: negative cable
- 4: transparent glass
- 5: battery slice group
- 51: battery string
- 511: battery slice
- 6: back plate
- 7: bus bar
- 8: insulation sheet
- 9: first encapsulation layer
- 10: second encapsulation layer
- 20: photovoltaic assembly
- 30: junction box

### DETAILED DESCRIPTION

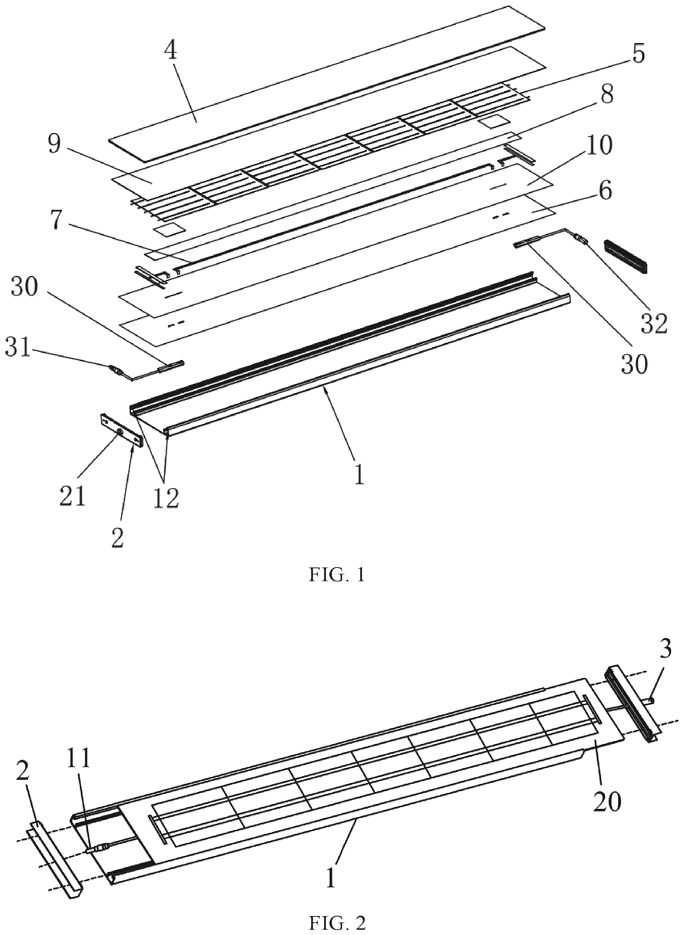

As shown in FIG. 1 and FIG. 2, an embodiment provides a photovoltaic slat for a louver. The photovoltaic slat for a louver includes a photovoltaic assembly 20, a first frame 1 and two second frames 2. Two sides of the first frame 1 are provided with two slide grooves 12 having opposite openings, and two side edges of the photovoltaic assembly 20 are respectively inserted into the two slide grooves 12. Each of the two second frames 2 is connected to a respective one of two ends of the first frame 1 which are not provided the two slide grooves 12, and the photovoltaic assembly 20 is clamped between the two second frames 2.

In the embodiment, the first frame 1 and each second frame 2 are connected by a fastener. Exemplarily, the fastener described above is a screw, and each second frame 2 is connected to the first frame 1 through two fasteners.

Optionally, the first frame 1 and the second frame 2 are both made of aluminum alloy, so that the requirement on strength of the photovoltaic slat when being applied to a louver is satisfied.

In the embodiment, the first frame 1 and the two second frames 2 are connected to form a rectangular frame, and the photovoltaic assembly 20 is limited in the rectangular frame, so that it is not necessary to punch holes on the photovoltaic assembly 20, and thus requirements on mounting the photovoltaic assembly 20 are reduced.

A lead groove 11 is disposed on a side of the first frame 1 facing the photovoltaic assembly 20, a photovoltaic cable 3 configured to draw electric energy generated by the photovoltaic assembly 20 is mounted in the lead groove 11, and a lead hole 21 for the photovoltaic cable 3 to pass through is provided in each second frame 2.

In the embodiment, the lead groove 11 is disposed on the first frame 1, the lead hole 21 is provided in the second frame 2, so that the photovoltaic cable 3 configured to draw electric energy generated by the photovoltaic assembly 20 is embedded in the lead groove 11 and passes out through the lead hole 21, and thus the photovoltaic cable 3 is orderly distributed and invisible, and thus the aesthetic effect of the photovoltaic slat for a louver is improved.

Optionally, the photovoltaic assembly 20 includes transparent glass 4, a battery slice group 5 and a back plate 6 which are sequentially stacked. A first side surface of the battery slice group 5 in a thickness direction of the battery slice group 5 is connected, in an encapsulating manner, to the transparent glass 4 through an EVA film forming a first encapsulation layer 9, and a second side surface of the battery slice group 5 in the thickness direction of the battery slice group 5 is encapsulated by the back plate 6 through an EVA film which forms a second encapsulation layer 10. In the embodiment, light transmittance of the transparent glass 4 is greater than 90%. The transparent glass 4 described above is hardened glass to effectively protect the battery slice group 5 against various complex weather.

Exemplarily, the back plate 6 is made of a transparent material. Alternatively the back plate 6 is black. Alternatively the back plate 6 is white. Alternatively a first side surface of the back plate 6 in a thickness direction of the back plate 6 is white, and a second side surface of the back plate 6 is black. A back plate 6 of a corresponding color may be selected according to the color of a building or an indoor daylighting requirement, so that the color of the back plate 6 is perfectly bended into the appearance of the building, and the color difference between the photovoltaic assembly 20 and the building is reduced.

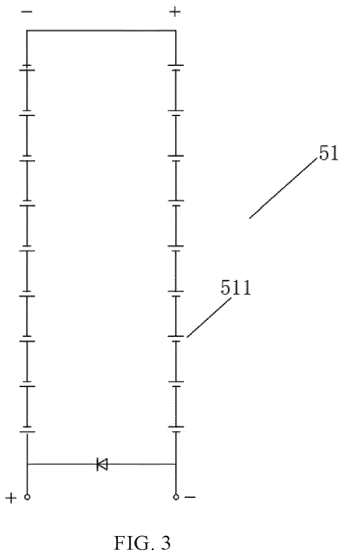

Optionally, the battery slice group 5 includes multiple battery strings 51 sequentially arranged. The multiple battery strings 51 are connected in parallel by a bus bar 7, and each battery string 51 includes multiple battery slices 511 sequentially connected in series (referring to FIG. 3). In the embodiment, a direction of a main grid line of each battery slice 511 is a length direction of the photovoltaic slat for a louver. Through the above setting, the obtained photovoltaic slat for a louver is strip-shaped, the size required by the louver is satisfied, and electric energy generated during operating of each battery string 51 is drawn conveniently.

The battery slice group 5 described above further includes an insulation sheet 8 clamped between the bus bar 7 and the battery slice group 5. The bus bar 7 is prevented by the insulation sheet 8 from contacting a battery slice 511 to which the bus bar 7 is not connected.

A side of the back plate 6 facing away from the battery slice group 5 is provided with a junction box 30 electrically connected to the battery slice group 5. The junction box 30 is electrically connected to the photovoltaic cable 3. The photovoltaic cable 3 includes a positive cable 31 and a negative cable 32 (referring to FIG. 1). The positive cable 31 and the negative cable 32 are disposed on two ends of the first frame 1 in a length direction of the first frame 1.

According to the photovoltaic slat for a louver provided by the present application, the first frame 1 and the two second frames 2 are connected to form a rectangular frame, the photovoltaic assembly 3 is limited in the rectangular frame, so that it is not necessary to punch holes on the photovoltaic assembly 20, and thus requirements on mounting the photovoltaic assembly 20 are reduced. The lead groove 11 is disposed on the first frame 1, the lead hole 21 is provided in the second frame 2, so that the photovoltaic cable 3 configured to draw the electric energy generated by the photovoltaic assembly 2 is embedded in the lead groove 11 and passes out through the lead hole 21, the photovoltaic cable 3 is orderly distributed and invisible, and thus the aesthetic effect of the photovoltaic slat for a louver is improved.

In the description of the present application, it is to be noted that orientations or position relations indicated by terms such as "center", "upper", "lower", "left", "right", "vertical", "horizontal", "in", "out" are orientations or position relations based on the drawings. These orientations or position relations are intended only to facilitate the description of the present application and simplify the description and not to indicate or imply that a device or element referred to must have such specific orientations or must be configured or operated in such specific orientations. Thus, these orientations or position relations are not to be construed as limiting the present application. In addition, terms such as "first" and "second" are used merely for the purpose of description and are not to be construed as indicating or implying relative importance. For example, the terms "first position" and "second position" refer to two different positions.

In the description of the present application, it is to be noted that unless otherwise expressly specified and limited, the terms "mounted", "connected to each other" or "connected" should be construed in a broad sense as securely connected, detachably connected or integrally connected; mechanically connected or electrically connected; directly connected to each other or indirectly connected to each other via an intermediary; or intraconnected between two components. For those of ordinary skill in the art, the specific meanings of the preceding terms in the present application may be understood based on specific situations.

## Claims

1. A photovoltaic slat for a louver, comprising:
a photovoltaic assembly (20);
a first frame (1), wherein two sides of the first frame (1) are provided with two slide grooves (12) having opposite openings, two side edges of the photovoltaic assembly (20) are respectively inserted into the two slide grooves (12), and a lead groove (11) is disposed on a side surface of the first frame (1) facing the photovoltaic assembly (20);
a photovoltaic cable (3), disposed in the lead groove (11) and configured to draw electric energy generated by the photovoltaic assembly (20); and
two second frames (2), wherein each of the two second frames (2) is connected to a respective one of two ends of the first frame (1) which are not provided with the two slide grooves (12), the photovoltaic assembly (20) is clamped between the two second frames (2), and a lead hole (21) for the photovoltaic cable (3) to pass through is provided in each of the two second frames (2).

2. The photovoltaic slat for a louver according to claim 1, wherein the first frame (1) and each of the two second frames (2) are connected by a fastener.

3. The photovoltaic slat for a louver according to claim 1, wherein the photovoltaic assembly (20) comprises transparent glass (4), a battery slice group (5) and a back plate (6) which are sequentially stacked, wherein two side surfaces of the battery slice group (5) in a thickness direction of the battery slice group (5) are respectively connected to the transparent glass (4) and the back plate (6) through encapsulation layers in an encapsulating manner.

4. The photovoltaic slat for a louver according to claim 3, wherein the back plate (6) is made of a transparent material, or
a color of the back plate (6) is set as one of followings: the back plate (6) is black; or the back plate (6) is white; or a first side surface of the back plate (6) in a thickness direction of the back plate (6) is white, and a second side surface of the back plate (6) in the thickness direction of the back plate (6) is black.

5. The photovoltaic slat for a louver according to claim 3, wherein the battery slice group (5) comprises a plurality of battery strings (51) sequentially arranged, wherein the plurality of battery strings (51) are connected in parallel by a bus bar (7), and each of the plurality of battery strings (51) comprises a plurality of battery slices (511) sequentially connected in series.

6. The photovoltaic slat for a louver according to claim 5, a direction of a main grid line of each of the plurality of battery slices (511) is a length direction of the photovoltaic slat for a louver.

7. The photovoltaic slat for a louver according to claim 5, wherein the battery slice group (5) further comprises an insulation sheet (8) clamped between the bus bar (7) and the battery slice group (5).

8. The photovoltaic slat for a louver according to claim 3, further comprising a junction box (30) electrically connected to the battery slice group (5), wherein the junction box (30) is disposed on a side surface of the back plate (6) facing away from the battery slice group (5), and the junction box (30) is electrically connected to the photovoltaic cable (3).

9. The photovoltaic slat for a louver according to claim 3, wherein light transmittance of the transparent glass (4) is greater than 90%.

10. The photovoltaic slat for a louver according to any one of claims 1 to 9, wherein the photovoltaic cable (3) comprises a positive cable (31) and a negative cable (32), wherein the positive cable (31) and the negative cable (32) are disposed on the two ends of the first frame (1) in a length direction of the first frame (1).
